(19) Europäisches Patentamt
European Patent Office
Office européen des brevets

(11) **EP 4 597 787 A2**

(12) **EUROPEAN PATENT APPLICATION**

(43) Date of publication:
**06.08.2025  Bulletin 2025/32**

(21) Application number: **25151355.2**

(22) Date of filing: **10.01.2025**

(51) International Patent Classification (IPC):
**H02J 7/00** (2006.01)          **G01R 31/396** (2019.01)

(52) Cooperative Patent Classification (CPC):
**H02J 7/005; G01R 31/396; H02J 7/0014;**
**H02J 7/0029; H02J 7/0047**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.02.2024  DE 102024102852**

(71) Applicant: **Skeleton Technologies GmbH**
**04420 Markranstädt (DE)**

(72) Inventor: **Trummal, Tarmo**
**01900 Großröhrsdorf (DE)**

(74) Representative: **KASTEL Patentanwälte PartG mbB**
**St.-Cajetan-Straße 41**
**81669 München (DE)**

(54) **ABNORMAL CELL DETECTION IN ENERGY STORAGE SYSTEMS AND BALANCING METHOD FOR SUCH ENERGY STORAGE SYSTEMS**

(57)    In order to improve ultracapacitor energy storage systems, the invention proposes a method for detecting an abnormal cell (26) in an energy storage system (10), the energy storage system (10) comprising a plurality of energy storage cells (18) that are connected in series and operatively coupled to a storage management system, the storage management system performing the steps of:
a) for each energy storage cell (18), obtaining cell data that are indicative of a cell leakage current level of the respective energy storage cell (18), the cell data at least including balancing-on-time;
b) for each energy storage cell (18), determining a cell leakage level based on the balancing-on-time (BOT); and
c) for each energy storage cell (18), determining the energy storage cell (18) to be an abnormal cell (26), if the cell leakage level resulting from step b) exceeds a predetermined threshold.

FIG. 3

EP 4 597 787 A2

**Description**

The invention relates to methods for detecting abnormal energy storage cells and balancing energy storage systems having such abnormal energy storage cells.

Energy storage systems that include multiple energy storage cells typically require some sort of management of cell voltages. This may have different causes, such as variations in manufacturing or - over time - degradation of the cells depending on environmental conditions or usage conditions, for example.

Energy storage cells as described herein may be classified into three varieties: batteries, capacitors and ultracapacitors (sometimes also called supercapacitors).

The term "battery" as used herein is an energy storage cell that stores electrical energy exclusively by electrochemical redox reaction. This typically includes primary batteries that can only be discharged. However, as used herein, the term "battery" exclusively means secondary battery, i.e., a battery that may be charged and discharged.

The term "capacitor" as used herein is an energy storage cell that stores electrical energy electrostatically.

The term "ultracapacitor" as used herein is a special kind of capacitor and may be further distinguished into a double-layer capacitor (DLC) that stores energy electrostatically using a Helmholtz double layer, a pseudocapacitor that stores electrical energy electrochemically by Faradaic electron charge-transfer such as intercalation or electrosorption, or a hybrid capacitor that uses both mechanisms of the DLC and the pseudocapacitor.

Different methods for detecting abnormally behaving cells and solutions to mitigate said behavior have been developed. Reference is made to the following approaches:

US 2015 / 0 044 527 A1 discloses a battery management circuit that senses individual voltage of each battery cell for detecting a failing cell. The battery management circuit prevents a failing cell from contributing to an output voltage of the battery.

US 11 133 133 B2, US 10 649 040 B2 and US 11 124 087 B2 disclose measures for identifying abnormal cells based on leakage current.

EP 3 800 762 A1 discloses a control unit that is capable of detecting an abnormal cell in a battery module and of controlling cell balancing.

US 7 683 575 B2 discloses a method for identifying and selectively disconnecting a faulty battery cell within a battery pack of several battery cells.

US 9 097 774 B2 discloses a method for identifying a faulty cell based on the amount the cell requires balancing.

US 9 866 043 B2 discloses an apparatus that disconnects a faulty cell by activating a sacrificial component by providing a current through the faulty cell.

US 2021 / 0 281 084 A1 discloses a method for performing a balancing operation based on a difference of voltages.

US 8 796 993 B2 discloses a method for balancing based on a Coulomb threshold level.

US 5 227 259 A discloses an apparatus for locating and electrically isolating failed cells in a network of cells within a battery.

US 5 894 212 A discloses a battery cell protection system that isolates a faulty cell.

US 10 317 477 B2 discloses an inspection method for a secondary battery in off-line mode.

It is the object of the invention to provide improved energy storage management measures, that are preferably particularly suited for ultracapacitors.

The object is achieved by the subject-matter of the independent claims. Preferred embodiments are subject-matter of the dependent claims.

The invention provides a method for detecting an abnormal cell in an energy storage system, the energy storage system comprising a plurality of energy storage cells that are connected in series and operatively coupled to a storage management system, the storage management system performing the steps of:

a) for each energy storage cell, obtaining cell data that are indicative of a cell leakage current level of the respective energy storage cell, the cell data at least including balancing-on-time (BOT);

b) for each energy storage cell, determining a cell leakage level based on the balancing-on-time (BOT); and

c) for each energy storage cell, determining the energy storage cell to be an abnormal cell, if the result of step b) exceeds a predetermined threshold and optionally meets at least one condition during a current detection period, and storing the respective energy storage cell as being an abnormal cell for the current detection period.

Preferably, step b) includes determining an imbalance change among the energy storage cells between the current detection period and a directly preceding detection period, wherein a first condition is met, if the imbalance change is smaller than a predetermined threshold.

Preferably, step b) includes determining a difference between a minimum BOT and a maximum BOT among the energy storage cells, wherein a second condition is met, if this difference is greater or equal to a predetermined threshold.

Preferably, step c) includes that the energy storage cell is determined to be an abnormal cell, if the result of step b) exceeds the predetermined threshold and each condition is met.

Preferably, step c) includes determining an abnormal cell to be a normal cell, if the result of step b) does not exceed the predetermined threshold or at least one condition is not met during the current detection period.

Preferably, steps a) to c) are carried out in a loop.

The invention provides a preparatory part of a balancing method for an energy storage system, the energy storage system comprising at least one energy storage module, each energy storage module having a plurality of energy storage cells, the method comprising a storage management system performing the steps of:

a) determining a normal cell voltage increase for normal energy storage cells due to allowing abnormal cells to drop, and determining a maximum allowed imbalance for abnormal cells;
b) determining a minimum and a maximum cell voltage of all energy storage cells excluding the abnormal cells;
c) determining a minimum and a maximum algorithm voltage for further processing in a balancing method by subtracting the normal cell voltage increase for normal energy storage cells due to allowing abnormal cells to drop from the minimum and maximum cell voltages obtained in step b).

The maximum allowed imbalance can be a predetermined value or can be calculated using the cell voltages and cell leakage characteristic. The leakage characteristic can be measured or modeled using methods well-known in the art.

The invention provides a balancing method for an energy storage system, the energy storage system comprising at least one energy storage module, each energy storage module having a plurality of energy storage cells, the method comprising a storage management system to perform the steps of:

a) detecting the presence of at least one abnormal cell;
b) determining a normal cell voltage increase due to allowing each abnormal cell to drop in voltage;
c) for each energy storage cell, setting the respective energy storage cell to a balance-on-state or a balance-off-state depending on the result of step b), wherein in the balance-on-state the operating voltage of the energy storage cell is decreased.

Preferably, in step a) the presence of each abnormal cell is detected by a preferred method.

Preferably, step b) includes carrying out a preferred preparatory part of the balancing method to determine the normal cell voltage increase due to allowing each abnormal cell to drop in voltage.

Preferably, step b) includes determining a cell balancing coefficient, and step c) includes setting the respective energy storage cell to the balancing-on-state, if the cell balancing coefficient exceeds a predetermined threshold, and setting the respective energy storage cell to the balancing-off-state otherwise.

Preferably, step b) includes determining a maximum allowed imbalance for abnormal cells and determining an abnormal delta voltage, wherein the abnormal delta voltage is indicative of a difference between the total decrease of abnormal cell voltages, and the allowed limit of total increase of normal cell voltages, and step c) includes setting the respective energy storage cell to the balancing-on-state, if the maximum allowed imbalance is smaller than or equal to zero or if the abnormal delta voltage is greater than or equal to zero, and to the balancing-off-state otherwise.

Preferably, the method is carried out in a loop.

The invention provides a storage management system comprising means to perform the disclosed methods.

The invention provides an energy storage module comprising a plurality of energy storage cells and a storage management system that is configured as a module controller.

The invention provides an energy storage rack comprising a plurality of energy storage modules, each including a plurality of energy storage cells, and a storage management system that is preferably formed by multiple module controllers or a rack controller.

The invention provides an energy storage system comprising at least one energy storage rack.

The invention provides a machine-readable data storage that includes instructions, that upon execution by a computer or microcontroller cause the computer or microcontroller to perform at least one step of a disclosed method, or that upon synthesizing in a programmable circuit chip, configure the circuit chip to perform at least one step of a disclosed method.

In some embodiments a method for detecting an abnormal cell in an energy storage system, the energy storage system comprising a plurality of energy storage cells that are connected in series and operatively coupled to a storage management system, includes the storage management system performing the steps of:

a) for each energy storage cell, obtaining cell data that are indicative of a cell leakage current level of the respective energy storage cell, the cell data at least including balancing-on-time;

b) for each energy storage cell, determining a cell leakage level based on the balancing-on-time (BOT); and
c) for each energy storage cell, determining the energy storage cell to be an abnormal cell, if the cell leakage level resulting from step b) exceeds a predetermined threshold.

Preferably, the method comprises a step d) of measuring an imbalance change and/or calculating a difference between a minimum and a maximum BOT, and performing step c) only, if in addition to the cell leakage level exceeding the predetermined threshold, the imbalance change is smaller than a second predetermined threshold and/or the difference between the minimum and maximum BOT is greater than or equal to a third predetermined threshold.

In some embodiments a preparatory part of a balancing method for an energy storage system, the energy storage system comprising at least one energy storage module, each energy storage module having a plurality of energy storage cells, includes a storage management system performing the steps of:

a) determining a normal cell voltage increase for normal energy storage cells due to allowing abnormal cells to drop, and determining a maximum change of the cell voltages;
b) determining a minimum and a maximum cell voltage of all energy storage cells excluding the abnormal cells;
c) determining a minimum and a maximum cell voltage of all energy storage cells including the abnormal cells in order to determine the minimum and maximum algorithm voltage for further processing.

In some embodiments a main part of a balancing method for an energy storage system, the energy storage system comprising at least one energy storage module, each energy storage module having a plurality of energy storage cells, includes a storage management system to perform the steps of:

a) obtaining input parameters for determining cell balancing coefficients;
b) performing a weighted balancing method with a set of cell balancing coefficients, wherein the set of cell balancing coefficients includes cell balancing coefficients each based on a cell voltage of the respective cell and the input parameters of step a).

Preferably, in step a) the input parameters are obtained by performing the preferred preparatory part of the balancing method. Preferably, the input parameters are selected from a group consisting of a minimum and a maximum algorithm voltage, and a minimum and a maximum module voltage of the energy storage module.
Preferably, in step b) each cell balancing coefficient is additionally based on a normal cell voltage increase for normal energy storage cells due to allowing abnormal cells to drop.
Preferably, in step b) each cell balancing coefficient is additionally based on an allowed system voltage imbalance.
In some embodiments a storage management system comprises means to perform the preferred methods.
In some embodiments an energy storage module comprises a plurality of energy storage cells and a preferred storage management system that is configured as a module controller.
In some embodiments an energy storage rack comprises a plurality of energy storage modules, each including a plurality of energy storage cells, and a preferred storage management system that is preferably formed by multiple module controllers or a rack controller.
In some embodiments an energy storage system comprises at least one preferred energy storage rack.
In some embodiments a machine-readable data storage includes instructions, that upon execution by a computer or microcontroller cause the computer or microcontroller to perform at least one step of a preferred method.
In some embodiments a machine-readable data storage includes instructions, that upon synthesizing in a programmable circuit chip, configure the circuit chip to perform at least one step of a preferred method.
Advantageous effects of the invention are described in more detail below. It should be noted that not all advantages must be present at the same time or to the same degree.
The idea presented herein has basically three parts. One part involves abnormal cell detection based on the balancing-on-time (BOT), which is the percentage of the total on-time/active time of the cell that is used for balancing. For example, if the storage cell is active for an active time $T_{on}$ and there was a balancing time of $t_{bal}$ of balancing the BOT is defined as $t_{bal}/T_{on}$. It is generally assumed that the BOT is associated with leakage current. It should be noted that the BOT can also be influenced by other factors that are not necessarily known, however, the leakage current seems to be more important than those.
Another part involves identifying the voltage balancing requirement for abnormal cells.
Still another part involves "dropping" the abnormal cells, which in this disclosure designates dropping of the operational voltage of the abnormal cells by keeping those cells at a lower voltage than the rest of the cells, while simultaneously keeping the entire system voltage the same, i.e., allowing a voltage offset for dropping those cells.
The main reason for the imbalance between the cell voltages in the ultracapacitors is leakage current difference between the different cells. In this rack level (cell to cell) balancing method, the cells with the highest voltage are preferably balanced by the balancing circuit before the cells with lower voltages.

In a system where imbalance in the rack is within the allowed limit the main goal of the balancing method is preferably keeping the imbalance within the allowed limit. In this case the balancing circuit can be used to equalize the leakage rates between the cells by discharging the cells with lower leakage rate. It can be said that the whole system will follow the cell with the highest leakage current.

In a balanced system, cells with lower leakage current have settled at a higher voltage than cells with higher leakage current. This means that cell leakage current can be characterized by using BOT (defined as percentage of a defined period that the balancing is on/active), where lower leakage current cells have higher BOT than higher leakage current cells. As leakage current steady-state value is voltage dependent, allowing a high leakage cell to have higher imbalance (difference to module maximum cell voltage) can reduce the BOT in the system.

Abnormal cell detection means detecting the cells that have a high leakage current. This detection is based on the BOT difference between individual cells in a module or system. It is assumed that a cell with high leakage current (abnormal cell) has the lowest voltage, when in a balanced state, and the rest of the cells (normal cells) are balanced ahead of it. This means that BOT indicates that the cell has a normal leakage current characteristic. Low or zero BOT means that this cell is rarely balanced and therefore it is assumed to have a higher leakage current compared other cells. Based on this, the BOT can be considered to represent the average leakage current characteristics of the cells. Using BOT difference within the module/system, individual cell BOTs and a predetermined limit for BOT, it is possible to find the abnormal cells.

Cell dropping, as it is called herein, is a functionality of the more general cell balancing methodology. One such cell balancing methodology is a weighted balancing algorithm. Cell dropping allows abnormal cells to have lower voltage than the rest of the cells in order allow a decrease of the BOT. The BOT can be reduced in this case due to the cell leakage current depending on the respective cell voltage. Allowing abnormal cells to operate at decreased voltage therefore allows decreasing the leakage current characteristics difference in the module. This function can be incorporated into the weighted balancing algorithm with system level balancing support functionality.

The approaches behind the cell dropping are: excluding the abnormal cells from rack level balancing, having additional allowed imbalance for abnormal cells, and having separate check on module level to keep the abnormal cells in allowed imbalance window. The exclusion of abnormal cells is not done physically, and the cells retain their energy storage functionality although at a lower voltage.

If an abnormal cell is detected in a module or the system, then that cell is excluded from the maximum and minimum voltage calculation. It should be noted that the cell is not electrically bypassed or disconnected. Additionally, cell voltages in the module where abnormal cells are detected are modified by distributing the decrease in abnormal cell voltages equally between the normal cells.

This can be illustrated by an example, where there are two modules connected in parallel (connected modules have the same terminal voltage due to their electrical connections) and their voltage is, e.g., 90 V before cell dropping and kept at 90 V after cell dropping.

For simplicity it can be assumed that there are no phenomena that cause the cell voltage to change without external help. An abnormal cell can be allowed to drop to a cell voltage of 1.1 V (discharging only this cell while holding voltage at 90 V), which means that each normal cell voltage increases by 0.04 V in the module.

This can be more than the allowed imbalance at that voltage, e.g. 0.03 V. Thus, the balancing algorithm may try to decrease the voltages of normal cells. This, however, would cause the abnormal cell voltage to rise again as the amount discharged from normal cells is charged into the abnormal cell. In this case the 0.04 V are instead subtracted from each cell to allow weighted balancing to operate correctly.

Embodiments of the invention are described in more detail with reference to the accompanying schematic drawings that are listed below

Fig. 1 depicts an embodiment of an energy storage system;
Fig. 2 depicts an embodiment of an energy storage module;
Fig. 3 depicts an embodiment of a method for abnormal cell detection;
Fig. 4 depicts an embodiment of a preparatory part of a balancing method; and
Fig. 5 depicts an embodiment of a main part of the balancing method.

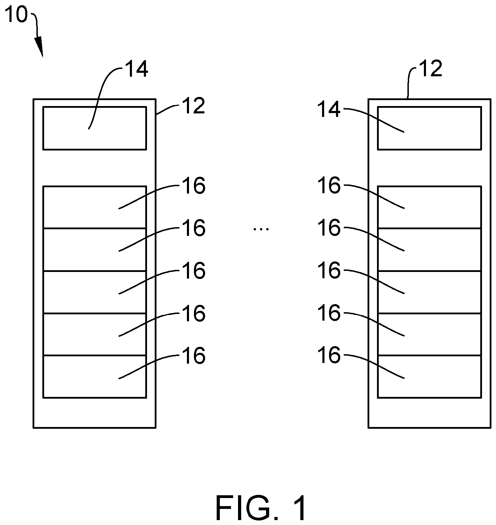

Referring to Fig. 1 an embodiment of an energy storage system 10 is schematically depicted. The energy storage system 10 may be used for grid stabilization, in particular for mitigating the effects of power sags or power disruptions, or for providing peak loads during ramp-up of power intensive machinery or equipment.

The energy storage system 10 may include one or more energy storage racks 12. The energy storage racks 12 that are suitably connected according to the application. The energy storage racks 12 are connected in parallel or in series depending on the application.

Each energy storage rack 12 includes a rack controller 14 and a plurality of energy storage modules 16. The rack controller 14 is configured to control the energy storage modules 16 that are installed in the respective energy storage rack 12. A plurality of rack controllers 14 may operationally form a system controller by communicating with each other. It is also possible for the energy storage system 10 to include a separate system controller (not shown) that communicates with and controls the energy storage racks 12 via the rack controllers 14.

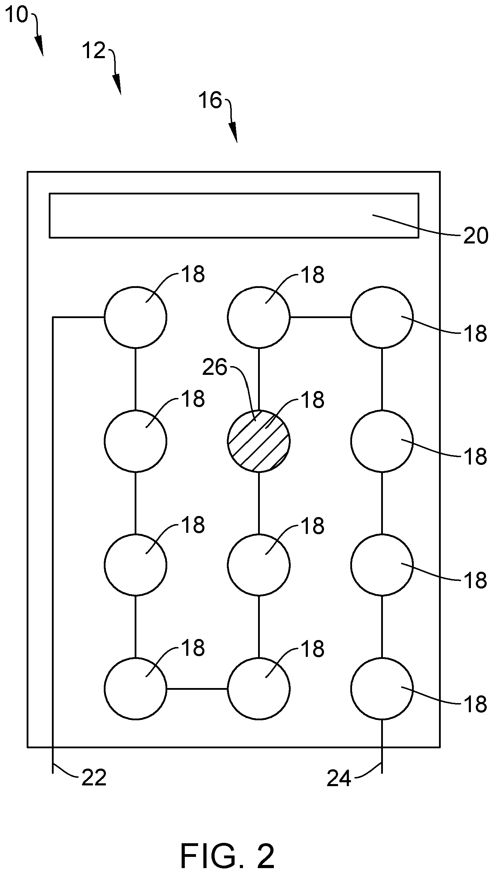

Referring to Fig. 2 the energy storage module 16 is described in more detail. The energy storage module 16 comprises a plurality of energy storage cells 18 and a module controller 20. The energy storage cells 18 are electrically connected in series. A first and second terminal 22, 24 are formed on the energy storage module 16, which allow electrical connection to other energy storage modules 16, preferably of the same energy storage rack 12.

The module controller 20 is configured to control general operation of the energy storage module 16, in particular charging and discharging of the energy storage cells 18. Furthermore, the module controller 20 is operatively coupled to each individual cell to allow controlling a cell voltage $V_{cell}$ of each individual energy storage cell 18. In particular the module controller 20 allows decreasing of the cell voltage $V_{cell}$ during balancing, preferably by discharging the respective energy storage cell 18 using a balancing circuit. In its simplest form the balancing circuit involves a switch, e.g., a transistor, and a balancing resistor.

Each module controller 20 may be operatively coupled to the rack controller 14. In some embodiments, two or more module controllers 20 may collectively form the rack controller 14 without a separate physical component present. It is also possible, that each module controller 20 is integrated into the rack controller 14 as a physical and/or software component thereof.

The rack controller 14, the system controller, and the module controller 20, as the case may be, may be collectively referred to as a storage management system 22.

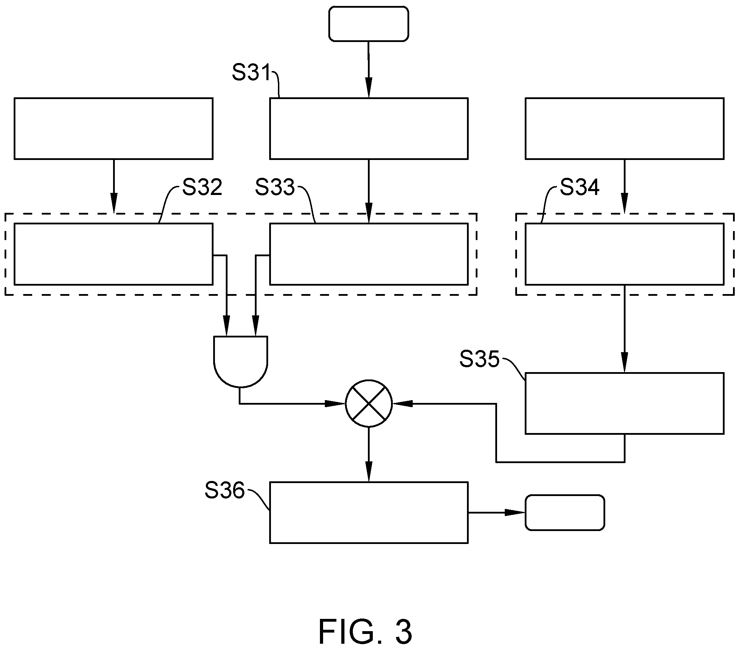

Referring to Fig. 2 and Fig. 3, a method for detecting an abnormal cell 26 is described in more detail. The method is performed in detection periods that can be numbered with n = 1, 2, ... Each detection period preferably lasts for a detection period time $t_{det}$. The detection period time $t_{det}$ can be predetermined or result from the amount of time needed for the storage management system 22 to execute the respective detection period. In other words, the length of the detection period time $t_{det, m}$ for detection test period m can be different from the detection period time $t_{det, n}$ for the detection period n.

In a data gathering step S31, the storage management system 22 gathers cell data of each energy storage cell 18. The cell data include information that is indicative of a cell leakage level and may also include further information. The cell data include, but are not limited to, the cell balancing-on-time $t_{BOT, i}$, where i designates the i-th cell. The cell data may further include any of a leakage level limit, a cell initial value, a cell voltage difference, and a cell voltage difference threshold limit.

In first validation step S32 the storage management system 22 determines the maximum BOT $t_{BOT, max}$ and the minimum BOT $t_{BOT, min}$ based on the cell BOTs $t_{BOT, i}$. If the storage management system 22 determines that a difference between the maximum BOT $t_{BOT, max}$ and the minimum BOT $t_{BOT, min}$ is greater than or equal to a predetermined threshold BOT, e.g. 30 %, the storage management system 22 sets a first detection condition to "true".

In a second validation step S33, the storage management system 22 also calculates an imbalance change $\Delta\Delta V = \Delta V_n - \Delta V_{n-1}$ among the energy storage cells 18 between the current detection period n and the previous detection period n-1. $\Delta V_n$, $\Delta V_{n-1}$ are the average imbalance during the respective detection periods n and n-1. If the imbalance change $\Delta\Delta V$ is smaller than a predetermined voltage imbalance threshold, the storage management system 22 sets a second detection condition to "true".

In a first identification step S34, the storage management system 22 determines an individual cell leakage level for each energy storage cell 18. The individual cell leakage level is determined based on the respective energy storage cell's 18 balancing-on-time $t_{BOT, i}$ and the difference between the maximum balancing-on-time $t_{BOT, max}$ and the minimum balancing-on-time $t_{BOT, min}$, i.e., $(t_{BOT, max} - t_{BOT, min}) - t_{BOT, i}$.

In a second identification step S35, the result of the first identification step S34 is compared with a predetermined abnormality threshold. If the result of the first identification step S34 is greater than or equal to the predetermined abnormality threshold, the respective energy storage cell 18 is identified as the abnormal cell 26.

In a storage step S36, the abnormal cell 26 is stored as behaving abnormal within the current detection time period $t_{det,}$ if, and preferably only if, in addition to the result of the second identification step S35, both the first and second validation steps S32 and S33 result in the first and second detection conditions being "true".

After the storage step S36, the current detection period n is completed and the next detection period n+1 can be started by the storage management system 22, as the case may be, after some delay or directly thereafter. It is also possible for the storage management system 22 to carry out an iteration of another method, before carrying out the next detection period n+1 of the detection method.

With this method the abnormal cell 26 is identified based on the cell BOT $t_{BOT, i}$. It should be noted that while the method was described in reference to a single energy storage module 16, the method disclosed herein is also applicable for energy storage racks 12 or the energy storage system 10 as a whole.

In the case of the energy storage racks 12 or the energy storage system 10, the energy storage cells 18 can be uniquely indexed and the whole configuration is preferably treated as a single entity, i.e., the method does not distinguish between the energy storage cells 18 being in different energy storage modules 16 or energy storage racks 12.

If only a single energy storage module 16 is involved, the storage management system 22 is preferably formed by the module controller 20.

If multiple energy storage modules 16 and a single energy storage rack 12 are involved, the storage management system 22 may be formed collectively by the module controllers 20 of the energy storage modules 16, or optionally by the rack controller 14.

If multiple energy storage racks 14 are involved, the storage management system 22 may be collectively formed by the rack controllers 14 and/or the module controllers 20. It is also possible that a separate system controller forms the storage management system 22 that controls the entire energy storage system 10.

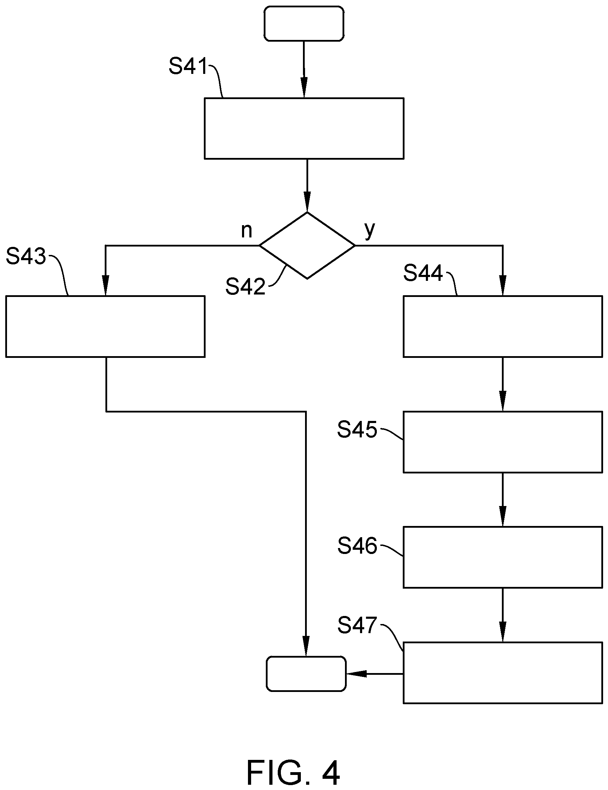

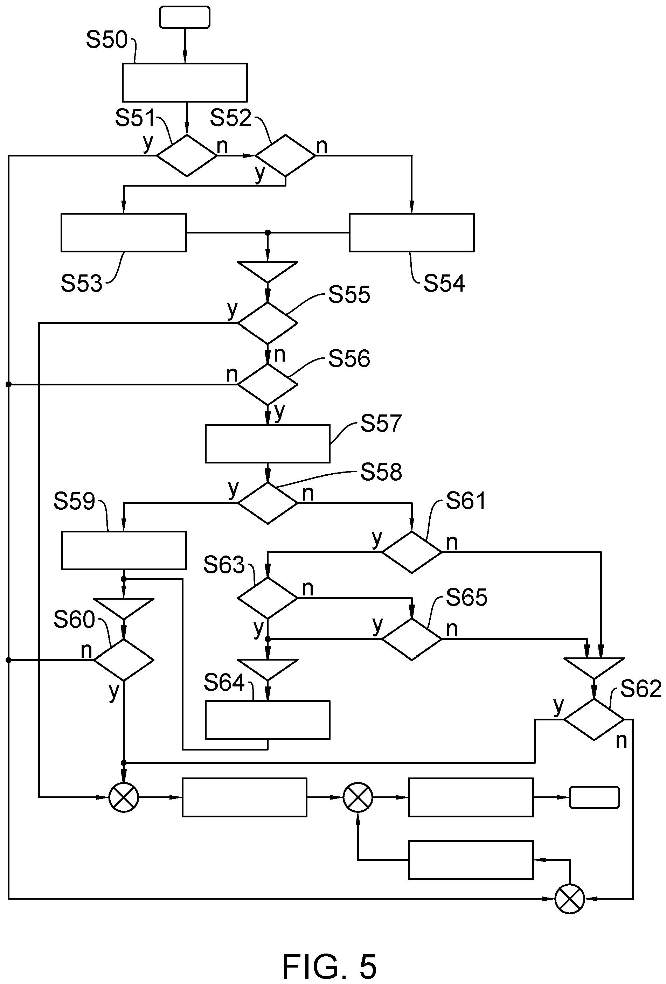

Referring to Fig. 4 and Fig. 5 an embodiment of a balancing method according to the invention is described.

Fig. 4 illustrates a preparatory part of the balancing method that determines certain useful inputs to the main part of the balancing method of Fig. 5.

In a data gathering step S41, the storage management system 22 gathers cell data of each energy storage cell 18. The cell data include information that is indicative of a cell leakage level. The cell data include, but are not limited to the abnormal cells 24, cell voltage Vi, maximum allowed imbalance for abnormal cells 24, maximum cell voltage increase for normal cells 18. In some embodiments the method for detecting abnormal cells 24 is carried out before. In some embodiments the method for detecting abnormal cells 24 can be carried out during this data gathering step S41.

In an abnormal cell detection checking step S42 it is checked, whether at least one abnormal cell 26 was detected by a suitable method, such as the previously described one. It is also possible to use a well-known abnormal cell detection method, as long as it is able to identify individual energy storage cells 18 as behaving abnormal.

If no abnormal cell 26 is detected, the method proceeds with an unmodified initiation step S43 in which the balancing method is initiated with neutral parameters, e.g., by calculating maximum and a minimum normal cell voltage $V_{min,\,norm}$, $V_{max,\,norm}$ for all energy storage cells.

If an abnormal cell 26 is detected, the method proceeds with a voltage determination step S44. In this step, the storage management system 22 determines a normal cell voltage increase $V_{HLCD\,Mdy}$ based on the maximum cell voltage $V_{max}$ of all the energy storage cells 18 and the individual cell voltages Vi according to:

$$V_{\text{HLCD Mdy}} = V_{\max} - \frac{(n-k) \cdot V_{\max} + \left(\sum_{i=1}^{k} V_i\right)}{n};$$

where $n$ is the total number of energy storage cells 18 and k is the total number of abnormal cells 26. The normal cell voltage increase $V_{HLCD\,Mdy}$ is indicative of the amount that the cell voltage of each normal energy storage cell 18 increases due to allowing the abnormal cells 26 to drop, i.e. decrease their respective voltage $V_i$.

Furthermore, the storage management system 22 determines an abnormal delta voltage $V_{HLCD\,abnormal\,delta}$ based on a predetermined limit $V_{HLCD\,limit}$, the average cell voltage $V_{avg}$, and the individual cell voltages $V_i$ according to:

$$V_{\text{HLCD abnormal delta}} = V_{\text{HLCD limit}} \cdot (n - k) - \left(k \cdot V_{\text{avg}} - \sum_{i=1}^{k} V_i\right);$$

where $n$ is the total number of energy storage cells 18 and k is the total number of abnormal cells 24. The abnormal delta voltage $V_{HLCD\,abnormal\,delta}$ is indicative of a difference between the total decrease of abnormal cell voltages, and the allowed limit of total increase of normal cell voltages.

In a maximum imbalance step S45, the storage management system 22 determines the maximum allowed imbalance for abnormal cells 24 based on a predetermined limit, e.g. 1 V, or calculated based on cell voltage and leakage current characteristics.

In an exclusion step S46, the storage management system 22 excludes the abnormal cells 24 from determining a maximum and a minimum normal cell voltage $V_{min,norm}$, $V_{max,norm}$ of all energy storage cells 18. In other words, the storage management system 22 determines the maximum and minimum normal cell voltage $V_{min.\,norm}$, $V_{max,\,norm}$ of all normal energy storage cells 18. It should be noted that the storage management system 22 only excludes the abnormal cells 24 for the purposes of calculation only. The abnormal cells 24 are thus not physically disconnected from the circuit or bypassed, but remain connected to the normal energy storage cells 18.

In a modified calculation step S47, the storage management system 22 determines the input minimum and maximum algorithm voltages $V_{algo,\,min}$, $V_{algo,\,max}$ as input parameters for the balancing method by subtracting the normal cells voltage increase due to allowing cells to drop $V_{HLCD\,Mdy}$ from the minimum and maximum normal cell voltage $V_{min,\,norm}$, $V_{max,\,norm}$. The minimum and maximum algorithm voltages $V_{algo,\,min}$, $V_{algo,\,max}$ are closely related to and preferably represent the minimum and maximum voltage as if there was no cell drop. After this step, the storage management system 22 may carry out the main part of the balancing method.

Referring to Fig. 5, the main part of the balancing method is described in more detail.

In a data gathering step S50, the storage management system 22 gathers cell data of each energy storage cell 18 and rack data of each energy storage rack 12, if applicable. The cell data include information that is indicative of a cell BOT. The cell data and/or rack data may include, but are not limited to, a balancing suspend flag, cell voltages $V_i$, minimum and maximum algorithm voltages $V_{algo, min}$, $V_{algo, max}$ as previously determined, module minimum and maximum voltages $V_{mod, min}$, $V_{mod, max}$, actual rack voltage $V_{rack, j}$, where j designates the energy storage rack 12, reference rack voltage $V_{rack, ref}$, nominal module voltage $V_{mod, nom}$, number of cells n, allowed rack offset, normal cells voltage increase due to allowing cells to drop $V_{HLCD\ Mdy}$, abnormal delta voltage $V_{HLCD\ abnormal\ delta}$, and/or maximum allowed imbalance for abnormal cells.

In a first branching step S51, the storage management system 22 determines, whether the balance suspend flag is set. If the balance suspend flag is set, the storage management system 22 main part of the balancing method is not performed and the next iteration of the preparatory part and/or the abnormal cell detection can be started.

If the balancing suspend flag is not set, the storage management system 22 proceeds to a second branching step S52. In this step S52, the storage management system 22 checks, whether the reference rack voltage $V_{rack, ref}$ is smaller than a predetermined balancing minimum limit. The balancing minimum limit basically is the threshold below which balancing is not possible due to a lack of balancing capacity. The balancing minimum limit can be determined experimentally.

If the storage management system 22 determines that the reference rack voltage $V_{rack, ref}$ is smaller than the balancing minimum limit, then all system balancing values, i.e. difference between the rack voltage $V_{rack, j}$ and the rack reference voltage $V_{rack, ref}$, and system balancing need for each energy storage cell 18 are set to 0, in a zeroing step S53.

If the storage management system 22 determines that the reference rack voltage $V_{rack, ref}$ is greater than or equal to the balancing minimum limit, the storage management system 22 determines a difference between the rack voltage $V_{rack, j}$ and the rack reference voltage $V_{rack, ref}$ in a voltage determination step S54.

Furthermore, the storage management system 22 determines the system balancing needs for each energy storage cell 18 individually, i.e. how much the respective cell voltage Vi should be changed.

After steps S53 and S54 the storage management system 22 proceeds to a third branching step S55. In this step, the storage management system 22 checks, whether the cell voltage Vi minus the normal cell voltage increase $V_{HLCD\ Mdy}$ exceeds the maximum balancing limit.

If so, the balancing flag is set to "true" and balancing is performed by the storage management system 22.

If not, the storage management system 22 proceeds to a fourth branching step S56. In this step, the storage management system 22 checks, whether the cell voltage Vi minus the normal cell voltage increase $V_{HLCD\ Mdy}$ exceeds the minimum balancing limit.

If not, the storage management system 22 performs no balancing and the next iteration of the preparatory part and/or the abnormal cell detection can be started.

If the condition is met, the storage management system 22 proceeds to calculate the allowed imbalance in an allowed imbalance determination step S57.

The storage management system 22 proceeds to a fifth branch step S58, in which it checks, whether the difference of the minimum and maximum algorithm voltages $V_{algo, min}$, $V_{algo, max}$ is greater than the allowed imbalance.

If so, each cell balancing coefficient $C_{cell\ bal}$ for rack level balancing is determined for each individual energy storage cell 18 in a first cell balancing determination step S59 as follows:

$$C_{\text{cell bal}} = \frac{V_i - V_{\text{HLCD Mdy}} + \Delta V_{sys\ bal} - V_{\min algo}}{V_{\max algo} - V_{\min algo}},$$

where $V_i$ is the cell voltage of the i-th cell, $V_{HLCD\ Mdy}$ is the normal cell voltage increase, $\Delta V_{sys\ bal}$ is the system balancing need for individual cell, $V_{min\ algo}$ is the minimum algorithm voltage, and $V_{max\ algo}$ is the maximum algorithm voltage.

After the step S59, the storage management system 22 proceeds to a sixth branching step S60. In this step, the storage management system 22 checks, whether the cell balancing coefficient $C_{cell\ bal}$ exceeds a coefficient limit threshold.

If so, the storage management system 22 sets the balancing flag to "true" and balances the respective energy storage cells 18 whose balancing coefficients exceeded the coefficient limit threshold.

If not, the storage management system 22 performs no balancing and the next iteration of the preparatory part and/or the abnormal cell detection can be started.

If in the fifth branch step S58, the storage management system 22 determines that the difference of the minimum and maximum algorithm voltages $V_{algo, min}$, $V_{algo, max}$ is smaller than or equal to the allowed imbalance determined in step S57 the storage management system 22 proceeds to a seventh branching step S61.

In this step S61, the storage management system 22 checks, whether the maximum allowed imbalance for abnormal cells exceeds 0.

If not, the storage management system 22 checks in an eighth branching step S62, whether a difference between the rack voltage $V_{rack}$ and the rack reference voltage $V_{rack, ref}$ exceeds the allowed rack imbalance.

If not, the balancing flag is set to "false" and the next iteration of the preparatory part and/or the abnormal cell detection can be started.

If the condition is met, the balancing flag is set to "true" and balancing is performed by the storage management system 22.

If in step S61, the storage management system 22 determines that the maximum allowed imbalance for abnormal cells exceeds 0, a ninth branching step S63 is performed.

In this step S63, the storage management system 22 checks, whether the difference of the minimum and maximum cell voltage $V_{min, mod}$, $V_{max, mod}$ in each energy storage module 18 where at least one abnormal cell 26 was detected is larger than the allowed imbalance for abnormal cells.

If so, the storage management system 22 calculates cell balancing coefficients $C_{cell\,bal}$ in a second cell balancing determination step S64 according to:

$$C_{\text{cell bal}} = \frac{V_i + \Delta V_{sys\,bal} - V_{\min mod}}{V_{\max mod} - V_{\min mod}};$$

where Vi is the cell voltage of the i-th cell, $\Delta V_{sysbal}$ is the system balancing need for individual cell, $V_{\min mod}$ is the module minimum voltage, and $V_{\max mod}$ is the maximum module voltage. The method then proceeds to the sixth branching step S60.

If in step S63, the condition is not met, a tenth branching step S65 checks, whether the abnormal delta voltage $V_{HLCD\,abnormal\,delta}$ is smaller than 0.

If so, the method proceeds to the second cell balancing determination step S64.

If not, the method proceeds to the eighth branching step S62.

**List of reference signs:**

10    energy storage system
12    energy storage rack
14    rack controller
16    energy storage module
18    energy storage cells
20    module controller
22    first terminal
24    second terminal
26    abnormal cell

S31    data gathering step
S32    first validation step
S33    second validation step
S34    first identification step
S35    second identification step
S36    storage step

S41    data gathering step
S42    abnormal cell detection checking step
S43    unmodified initiation step
S44    voltage determination step
S45    maximum imbalance step
S46    exclusion step
S47    modified calculation step

S50    data gathering step
S51    first branching step
S52    second branching step

S53  zeroing step
S54  voltage determination step
S55  third branching step
S56  fourth branching step
S57  allowed imbalance determination step
S58  fifth branch step
S59  first cell balancing determination step
S60  sixth branching step
S61  seventh branching step
S62  eight branching step
S63  ninth branching step
S64  second cell balancing determination step
S65  tenth branching step

**Claims**

1. A method for detecting an abnormal cell (26) in an energy storage system (10), the energy storage system (10) comprising a plurality of energy storage cells (18) that are connected in series and operatively coupled to a storage management system, the storage management system performing the steps of:

    a) for each energy storage cell (18), obtaining cell data that are indicative of a cell leakage current level of the respective energy storage cell (18), the cell data at least including balancing-on-time (BOT);
    b) for each energy storage cell (18), determining a cell leakage level based on the balancing-on-time (BOT); and
    c) for each energy storage cell (18), determining the energy storage cell (18) to be an abnormal cell (26), if the result of step b) exceeds a predetermined threshold and optionally meets at least one condition during a current detection period, and storing the respective energy storage cell (18) as being an abnormal cell (26) for the current detection period.

2. The method according to claim 1, wherein step b) includes:

    b1) determining an imbalance change among the energy storage cells (18) between the current detection period and a directly preceding detection period,
    wherein a first condition is met, if the imbalance change is smaller than a predetermined threshold; and/or
    b2) determining a difference between a minimum BOT and a maximum BOT among the energy storage cells (18), wherein a second condition is met, if this difference is greater or equal to a predetermined threshold.

3. The method according to claim 2, wherein step c) includes:
    c1) that the energy storage cell (18) is determined to be an abnormal cell (26), if the result of step b) exceeds the predetermined threshold and each condition is met.

4. The method according to any of the preceding claims, wherein steps a) to c) are carried out in a loop.

5. A preparatory part of a balancing method for an energy storage system (10), the energy storage system (10) comprising at least one energy storage module (16), each energy storage module (16) having a plurality of energy storage cells (18), the method comprising a storage management system performing the steps of:

    a) determining a normal cell voltage increase for normal energy storage cells (18) due to allowing abnormal cells (26) to drop, and determining a maximum imbalance for abnormal cells (26);
    b) determining a minimum and a maximum cell voltage of all energy storage cells (18) excluding the abnormal cells (26);
    c) determining a minimum and a maximum algorithm voltage for further processing in a balancing method by subtracting the normal cell voltage increase for normal energy storage cells (18) due to allowing abnormal cells (26) to drop from the minimum and maximum cell voltages obtained in step b).

6. A balancing method for an energy storage system (10), the energy storage system (10) comprising at least one energy storage module (16), each energy storage module (16) having a plurality of energy storage cells (18), the method comprising a storage management system to perform the steps of:

a) detecting the presence of at least one abnormal cell (26);

b) determining a normal cell voltage increase due to allowing each abnormal cell (26) to drop in voltage;

c) for each energy storage cell (18), setting the respective energy storage cell (18) to a balance-on-state or a balance-off-state depending on the result of step b), wherein in the balance-on-state the operating voltage of the energy storage cell (18) is decreased.

7. The method according to claim 6, wherein in step a) the presence of each abnormal cell (26) is detected by a method according to any of the claims 1 to 4.

8. The method according to claim 6 or 7, wherein step b) includes carrying out a method according to claim 5.

9. The method according to any of the claims 6 to 8, wherein step b) includes determining a cell balancing coefficient, and step c) includes setting the respective energy storage cell (18) to the balancing-on-state, if the cell balancing coefficient exceeds a predetermined threshold, and setting the respective energy storage cell (18) to the balancing-off-state otherwise.

10. The method according to any of the claims 6 to 9, wherein step b) includes determining a maximum allowed imbalance for abnormal cells (26) and determining an abnormal delta voltage, wherein the abnormal delta voltage is indicative of a difference between the total decrease of abnormal cell voltages, and the allowed limit of total increase of normal cell voltages, and step c) includes setting the respective energy storage cell (18) to the balancing-on-state, if the maximum allowed imbalance is smaller than or equal to zero or if the abnormal delta voltage is greater than or equal to zero, and to the balancing-off-state otherwise.

11. A storage management system comprising means to perform the methods according to any of the preceding claims.

12. An energy storage module (16) comprising a plurality of energy storage cells (18) and a storage management system according to claim 11 that is configured as a module controller (20).

13. An energy storage rack (12) comprising a plurality of energy storage modules (16), each including a plurality of energy storage cells (18), and a storage management system according to claim 11 that is preferably formed by multiple module controllers (20) or a rack controller.

14. An energy storage system (10) comprising at least one energy storage rack (12) according to claim 13.

15. A machine-readable data storage that includes instructions, that upon execution by a computer or microcontroller cause the computer or microcontroller to perform at least one step of a method according to any of the claims 1 to 10, or that upon synthesizing in a programmable circuit chip, configure the circuit chip to perform at least one step of a method according to any of the claims 1 to 10.

FIG. 1

FIG. 2

FIG. 3

EP 4 597 787 A2

S41

S43

S42

S44

S45

S46

S47

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20150044527 A1
- US 11133133 B2
- US 10649040 B2
- US 11124087 B2
- EP 3800762 A1
- US 7683575 B2
- US 9097774 B2
- US 9866043 B2
- US 20210281084 A1
- US 8796993 B2
- US 5227259 A
- US 5894212 A
- US 10317477 B2